# EUROPEAN PATENT APPLICATION

(11) **EP 4 040 481 A1**
(43) Date of publication of application: **10.08.2022**
(21) Application number: 22153616.2
(22) Date of filing: 27.01.2022
(51) Int. Cl.: H01L 23/498, H01L 23/495, H01L 23/538, H01L 25/16

(54) **ELECTRONIC DEVICE**

(30) Priority: 09.02.2021 US 202163147239 P; 19.11.2021 CN 202111397829; 26.01.2022 CN 202210095748
(71) Applicant: InnoLux Corporation, Chu-Nan, Miao-Li County 35053 (TW)
(72) Inventor: CHI, Jen-Hai, 35053 Chu-Nan, Miao-Li County (TW); YEH, Chen-Lin, 35053 Chu-Nan, Miao-Li County (TW); HSIEH, Chih-Yung, 35053 Chu-Nan, Miao-Li County (TW)
(74) Representative: Becker, Eberhard

(57) **Abstract**

The disclosure provides an electronic device, including a substrate, a first conductor layer, a first insulating layer, an electronic component, and a driving structure. The first conductor layer is arranged on the substrate. The first insulating layer is disposed on the first conductor layer. The electronic component is arranged on the first insulating layer and coupled to the first conductor layer. The driving structure is coupled to the electronic component. The electronic device in the disclosure can have improved structural reliability.

## Description

### BACKGROUND

### Field of the Disclosure

The disclosure relates to an electronic device, in particular to an electronic device with improved structural reliability.

### Description of Related Art

In current electronic devices, the thermal expansion coefficient of a substrate is very different from the thermal expansion coefficient of a conductive layer. Therefore, when a driving structure is fabricated on the substrate, the substrate will warp due to the high-temperature process, which will affect the structural reliability of the overall electronic device.

### SUMMARY OF THE DISCLOSURE

The disclosure provides an electronic device with better structural reliability.

According to an embodiment of the disclosure, an electronic device includes a substrate, a first conductor layer, a first insulating layer, an electronic component, and a driving structure. The first conductor layer is arranged on the substrate. The first insulating layer is disposed on the first conductor layer. The electronic component is arranged on the first insulating layer and coupled to the first conductor layer. The driving structure is coupled to the electronic component.

In summary, in the embodiments of the disclosure, since the electronic component is disposed on the first insulating layer and is coupled to the first conductor layer, and the driving structure is coupled to the electronic component, the electronic device of the disclosure can have improved structural reliability.

In order to make the above-mentioned features and advantages of the disclosure more obvious and comprehensible, the embodiments are described below with reference to the accompanying drawings for detailed description as follows.

### BRIEF DESCRIPTION OF THE DRAWINGS

The accompanying drawings are included for facilitate understanding of the disclosure, and the accompanying drawings are incorporated into this specification and constitute a part of this specification. The drawings illustrate the embodiments of the disclosure, and together with the description serve to explain the principles of the disclosure.
FIG. 1 is a schematic view of an electronic device according to an embodiment of the disclosure.
FIG. 2A is a schematic partial cross-sectional view of a main region in the electronic device of FIG. 1.
FIG. 2B is a schematic partial cross-sectional view of a main region in an electronic device according to another embodiment of the disclosure.
FIG. 2C is a schematic partial cross-sectional view of a main region in an electronic device according to still another embodiment of the disclosure.

### DESCRIPTION OF EMBODIMENTS

The disclosure can be understood by referring to the following detailed description in combination with the accompanying drawings. It should be noted that in order to make it easy for the reader to understand and for the simplicity of the drawings, the multiple drawings in this disclosure only depict a part of the electronic device, and the specific components in the drawings are not drawn according to actual scale. In addition, the number and size of each component in the drawings are only for exemplary purpose, and are not intended to limit the scope of the disclosure.

Throughout the disclosure and the appended claims, certain words are used to refer to specific components. Those skilled in the art should understand that electronic device manufacturers may refer to the same components by different names. The disclosure does not intend to distinguish those components with the same function but different names.

In the following description and claims, the terms "contain" and "include" are open-ended terms, so they should be interpreted as "include but not limited to...".

In addition, relative terms, such as "below" or "bottom" and "above" or "top" may be used in the embodiments to describe the relative relationship between one component and another component in the drawing. It can be understood that if the device in the drawing is turned upside down, the components described on the "lower" side will become the components on the "upper" side.

In some embodiments of the disclosure, terms such as "connected", "interconnected", etc. regarding bonding and connection, unless specifically defined, can mean that two structures are in direct contact, or that two structures are not directly (indirectly) in contact, where there are other structures located between the two structures. Moreover, the terms of joining and connecting can also include the case where both structures are movable or both structures are fixed. In addition, the term "coupling" includes the transfer of energy between two structures through direct or indirect electrical connection, or the transfer of energy between two separate structures through mutual induction.

It should be understood that when an component or layer is referred to as being "on" or "connected to" another component or layer, it can be directly set on said other component or layer or directly connected to said other component or layer, or there is an intervening component or layer between the two (indirect connection). In contrast, when a component is referred to as being "directly on" or "directly connected to" another component or layer, there are no intervening components or layers between the two.

The terms "about", "equal to", "equivalent to" or "same", "substantially" or "approximately" are generally interpreted as being within 20% of a given value or range, or interpreted as being within 10%, 5%, 3%, 2%, 1%, or 0.5% of a given value or range.

As used herein, the terms "film" and/or "layer" can refer to any continuous or discontinuous structure and material (such as materials deposited by the methods disclosed herein). For example, the film and/or layer may include two-dimensional materials, three-dimensional materials, nanoparticles, or even partial or complete molecular layers, or partial or complete atomic layers, or clusters of atoms and/or molecules. The film or layer may comprise a material or layer having pinholes, which may be at least partially continuous.

Although the terms first, second, third... can be used to describe a variety of components, the components are not limited by this term. This term is only used to distinguish a single component from other components in the specification. Different terminologies may be adopted in claims, and replaced with the first, second, third... in accordance with the order of components specified in the claims. Therefore, in the following description, the first component may be described as the second component in the claims.

Unless otherwise defined, all terms (including technical and scientific terms) used herein have the same meanings commonly understood by those having ordinary skill in the art. It is understandable that these terms, such as those defined in commonly used dictionaries, should be interpreted as having a meaning consistent with the relevant technology and the background or context of this disclosure, rather than being interpreted in an idealized or overly formal way, unless specifically defined here.

It should be noted that the following embodiments can replace, recombine, and mix the technical features of several different embodiments without departing from the spirit of the disclosure to complete other embodiments.

The electronic device of the disclosure may include a display device, an antenna device, a sensing device, a light-emitting device, or a tiling device, but is not limited thereto. The electronic device may be a bendable or flexible electronic device. The electronic device may include electronic components. Electronic components can include passive components, active components or the combination thereof, such as capacitors, resistors, inductors, variable capacitors, filters, diodes, transistors, sensors, microelectromechanical system (MEMS) components, and liquid crystal chips etc., but not limited thereto. The diode may include light emitting diode or non-light emitting diode. The diode may include P-N junction diode, PIN diode, or constant current diodes. Light emitting diodes may include, for example, organic light emitting diodes (OLED), mini LED, micro LED, quantum dot LED, fluorescence, phosphor or other suitable materials, or a combination of the above, but not limited thereto. The sensor may, for example, include capacitive sensors, optical sensors, electromagnetic sensors, fingerprint sensors (FPS), touch sensors, antenna, or pen sensor, etc., but not limited thereto. Hereinafter, the display device will be used as an electronic device to illustrate the content of the disclosure, but the disclosure is not limited thereto.

Reference will now be made in detail to the exemplary embodiments of the disclosure, and examples of the exemplary embodiments are illustrated in the accompanying drawings. Whenever possible, the same reference symbols are used in the drawings and descriptions to indicate the same or similar parts.

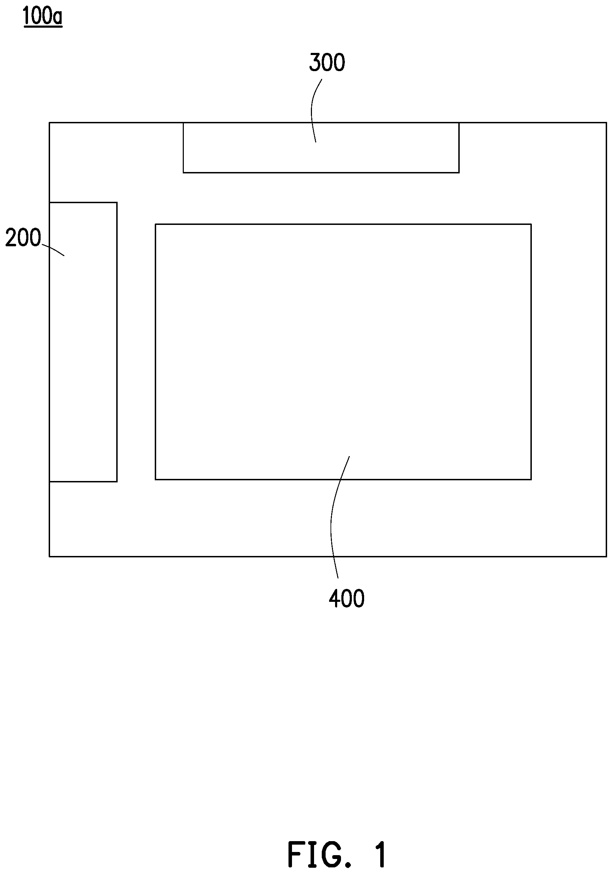

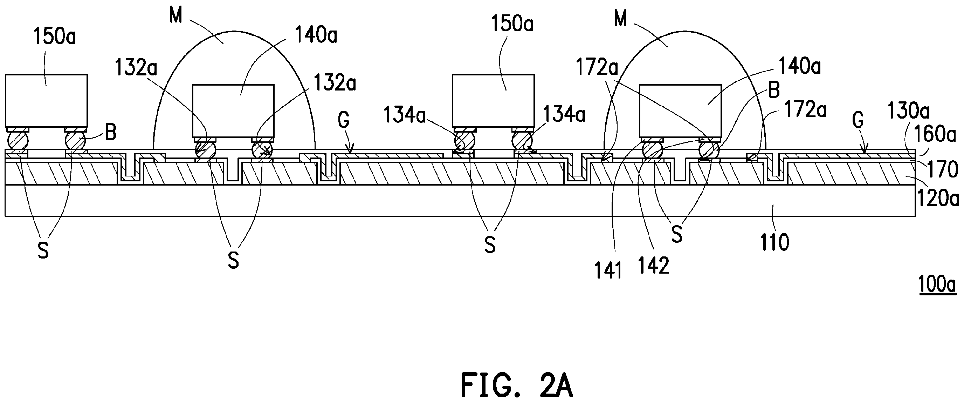

FIG. 1 is a schematic view of an electronic device according to an embodiment of the disclosure. FIG. 2A is a schematic partial cross-sectional view of a main region in the electronic device of FIG. 1. Please refer to FIG. 1 first. In this embodiment, a gate driver 200 and a multiplexer 300 are also provided around the electronic device 100a. The gate driver 200 is coupled to a timing controller (not shown) and provides multiple gate signals. The electronic device 100a includes a main region 400. The main region 400 includes a plurality of electronic components, a plurality of source lines, and a plurality of gate lines (not shown). Each electronic component is coupled to a corresponding source line and a corresponding gate line. Each gate line is coupled to the gate driver 200 to receive the corresponding gate signal, and turn on a row of electronic components according to the corresponding gate signal. Each source line is coupled to the multiplexer 300 to receive the corresponding data signal and write the data signal into a row of turned-on electronic components.

In detail, please refer to FIG. 2A. In this embodiment, the electronic device 100a includes a substrate 110, a first conductor layer 120a, a first insulating layer 130a, an electronic component 140a, and a driving structure 150a. The first conductor layer 120a is disposed on the substrate 110. The first insulating layer 130a is disposed on the first conductor layer 120a. The electronic component 140a is disposed on the first insulating layer 130a and is coupled to the first conductor layer 120a. The driving structure 150a is coupled to the electronic component 140a. The gate driver 200 includes integrated circuits (IC), micro integrated circuits (micro IC) or thin film transistors which are formed on the substrate 110. The multiplexer 300 includes IC, micro IC or thin film transistors which are formed on the substrate 110.

The substrate 110 includes, for example, a polymer film, a porous film, a glass substrate, a glass fiber (FR4) substrate, ceramic, or other suitable materials or a combination of the above materials, but not limited thereto. The thickness of the substrate 110 is, for example, between 500 micrometers (µm) and 700µm, but it is not limited thereto. The material of the first conductor layer 120a includes, for example, copper, aluminum, silver, gold, or any conductive material or a combination of the foregoing materials. It can be a single-layer conductor structure or a multilayer conductor structure. The thickness of the overall first conductor layer 120a is, for example, between 1µm and 20µm, and thus having better conductivity, which is adaptive to large current or facilitates heat dissipation. In addition, from the top view of the electronic device 100a, the ratio of the area of the first conductor layer 120a to the area of the substrate 110 may be between 80% and 99%. The first insulating layer 130a has an opening 132a (i.e., a first opening) and an opening 134a (i.e., a second opening). The electronic component 140a is coupled to the first conductor layer 120a through the opening 132a of the first insulating layer 130a. The driving structure 150a is disposed on the first insulating layer 130a, and is coupled to the first conductor layer 120a through the opening 134a of the first insulating layer 130a. The driving structure 150a of this embodiment is coupled to the electronic component 140a through the first conductor layer 120a. The driving structure 150a can control at least one electronic component 140a. The driving structure 150a includes, for example, integrated circuits (IC), micro integrated circuits (micro IC), transistors, silicon controlled rectifiers, diodes, valves, or a chip which have a second substrate and thin film transistors formed thereon, but not limited thereto. The second substrate can include a polymer film, a porous film, a glass substrate, a glass fiber (FR4) substrate, a ceramic, or a combination of the foregoing materials. The above-mentioned chip can be packaged or a die. The substrate of the aforementioned chip may include a glass substrate, a polymer film, a printed circuit board, a base layer formed of ceramics, or a combination of the above, but is not limited thereto. The material of the channel layer (not shown) of the thin film transistor may include low-temperature polysilicon, amorphous silicon, oxide semiconductor, organic semiconductor, or a group III-V compound semiconductor, but not limited thereto. The driving structure 150a can be bonded on the substrate 110 by flip chip bonding, surface mount technology or chip on board bonding.

In some embodiments, the electronic device 100a can adjust the property of the electromagnetic wave fed in, such as adjusting the amplitude, phase, or frequency and other properties of the electromagnetic wave, but the disclosure is not limited thereto. In addition, the first conductor layer 120a can be used to guide electromagnetic waves. Under the circumstances, the thickness of the first conductor layer 120a needs to be greater than or equal to its skin depth. The formula for the skin depth is as follows:

In the formula, *ρ* =the resistivity of the first conductor layer, *ω*=2π^{∗}f, f = frequency of electromagnetic wave, and *µ* = absolute permeability of the first conductor layer.

In other words, the skin depth of the first conductor layer 120a varies according to the frequency of the electromagnetic wave to be guided and the material of the first conductor layer 120a.

As shown in FIG. 2A, the electronic device 100a of this embodiment further includes a second conductor layer 160a, which is disposed between the first conductor layer 120a and the first insulating layer 130a, and is coupled to the electronic component 140a and the driving structure 150a. The material of the second conductor layer 160a can be the same as that of the first conductor layer 120a, but it is not limited thereto. Furthermore, the electronic device 100a of this embodiment may further include a second insulating layer 170 disposed between the first conductor layer 120a and the first insulating layer 130a. The second insulating layer 170 has an opening 172a, and the second conductor layer 160a may be coupled to the first conductor layer 120a through the opening 172a. Additionally, the electronic component 140a of this embodiment can be packaged through an encapsulant M, and the electronic component 140a and the driving structure 150a can be respectively coupled to the first conductor layer 120a and the second conductor layer 160a through a solder B, but it is not limited thereto. The solder B is, for example, eutectic solder, and the material of the eutectic solder is, for example, gold-tin alloy, silver-tin alloy, or other suitable materials or a combination of the foregoing materials, but not limited thereto.

In this embodiment, the electronic component 140a and the driving structure 150a can be separately fabricated and then disposed on the substrate 110 by flip chip bonding, surface mount technology or chip on board bonding. That is, the electronic component 140a and the driving structure 150a are disposed on the substrate 110 instead of being formed on the substrate 110 by means of a semiconductor process. Therefore, in order to improve the reliability of bonding, in this embodiment, a conductive pad S is provided at a portion of the second conductor layer 160a exposed by the opening 134a and a portion of the first conductor layer 120a exposed by the opening 172a. The conductive pad S is, for example, Electroless Nickel Immersion Gold (ENIG), Electroless Nickel Electroless Palladium Immersion Gold (ENEPIG), or other suitable materials or a combination of the foregoing materials, but not limited thereto. In addition, the driving structure 150a may have a substrate (not shown). The substrate may include, for example, a polymer film, glass, silicon, gallium arsenide, gallium nitride, silicon carbide, or sapphire, but is not limited thereto.

Please refer to FIG. 2A again. For instance, the driving structure 150a, for example, generates a direct current (DC) signal, and the DC signal can be coupled to the first conductor layer 120a through the second conductor layer 160a and through the opening 172a. Then, the first conductor layer 120a can couple the DC signal to a pin 141 of the electronic component 140a. The other pin 142 of the electronic component 140a can be coupled to the ground line G in the second conductor layer 160a through the first conductor layer 120a. In this embodiment, the electronic component 140a and the first conductor layer 120a are electrically connected to achieve coupling, but the disclosure is not limited thereto.

In short, since the electronic component 140a and the driving structure 150a of this embodiment are separately fabricated, they are assembled on the substrate 110 by flip chip bonding. The electronic component 140a is disposed on the first insulating layer 130a and coupled to the first conductor layer 120a, and the driving structure 150a is coupled to the electronic component 140a. Therefore, compared to directly fabricating the driving structure 150a on the substrate by means of a semiconductor process, the present embodiment can reduce the warpage of the substrate 110 caused by the high-temperature process during the fabrication of the driving structure 150a, which allows the electronic device 100a of the present embodiment to have improved structural reliability.

It should be noted here that the following embodiments use the reference numbers and part of the content of the foregoing embodiments. Similar numbers are used to indicate the same or similar components, and the description of the same technical content is omitted. For the description of the omitted parts, reference may be made to the foregoing embodiments, and the following embodiments will not be repeat the same content.

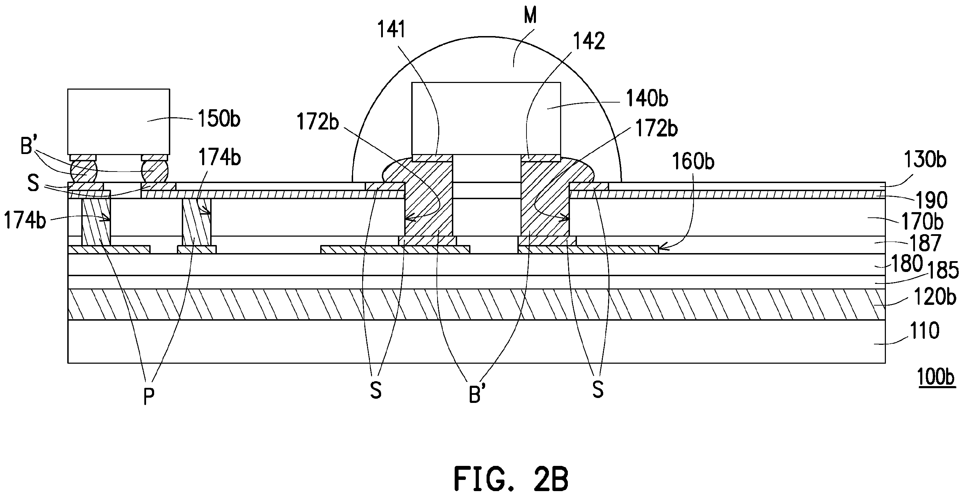

FIG. 2B is a schematic partial cross-sectional view of a main region in an electronic device according to another embodiment of the disclosure. Referring to FIG. 2A and FIG. 2B both, the electronic device 100b of this embodiment is similar to the electronic device 100a of FIG. 2A. In this embodiment, the second insulating layer 170b is disposed between the first conductor layer 120b and the first insulating layer 130b. The driving structure 150b is disposed on the second insulating layer 170b. The third conductor layer 190 is disposed on the second insulating layer 170b. The second insulating layer 170b has an opening 172b (i.e., a first opening) and an opening 174b (i.e., a second opening). The difference between the electronic device 100b of this embodiment and the electronic device 100a of FIG. 2A is that the electronic component 140b is coupled to the second conductor layer 160b through the opening 172b of the second insulating layer 170b, and the second conductor layer 160b is coupled to the first conductor layer 120b. The driving structure 150b is coupled to the second conductor layer 160b through the opening 174b of the second insulating layer 170b, and the second conductor layer 160b is coupled to the first conductor layer 120b. In this embodiment, the pin 141, the pin 142, and the second conductor layer 160b of the electronic component 140b are electrically connected to achieve coupling, while the second conductor layer 160b and the first conductor layer 120b are mutually induced to achieve coupling, but the disclosure is not limited thereto.

Furthermore, in this embodiment, the first conductor layer 120b can guide electromagnetic waves, and the third insulating layer 180 and/or the connection layer 185 can be included between the first conductor layer 120b and the second conductor layer 160b. Here, the substrate 110 and the third insulating layer 180 and the second insulating layer 170b can be connected together through a heterogeneous interface, which means that the second insulating layer 170b can be connected to the third insulating layer 180 through the connection layer 187. The third insulating layer 180 can be connected to the third conductor layer 190 on the substrate 110 through the connection layer 185, but the disclosure is not limited thereto. The connection layer 185 and the connection layer 187 can be, for example, an insulating layer or an adhesive layer, which is not limited herein. In this embodiment, the material of the third insulating layer 180 and the second insulating layer 170b may be the same as that of the substrate 110, and no repetition is incorporated herein.

Furthermore, in this embodiment, the solder B' is filled in the opening 172b of the second insulating layer 170b, and the electronic component 140b is coupled to the second conductor layer 160b and the first conductor layer 120b through the solder B'. In addition, the conductive component P is disposed in the opening 174b of the second insulating layer 170b, and is coupled to the first conductor layer 120b and the second conductor layer 160b. The driving structure 150b is coupled to the first conductor layer 120b through the solder B', the conductive pad S, the second conductor layer 160b, and the conductive component P. The driving structure 150b is also coupled to the electronic component 140b through the solder B', the conductive pad S, the second conductor layer 160b, the conductive pad S, and the solder B'. That is, the driving structure 150b of this embodiment is coupled to the electronic component 140b through the second conductor layer 160b.

In short, the electronic device 100b of this embodiment includes at least three insulating layers (i.e., the first insulating layer 130b, the second insulating layer 170b, and the third insulating layer 180). Since the electronic component 140b and the driving structure 150b of this embodiment are separately fabricated and then assembled on the substrate 110 by means of flip chip bonding, the electronic component 140b is disposed on the first insulating layer 130b and is coupled to the first conductor layer 120b, and the driving structure 150b is coupled to the electronic component 140b. Therefore, compared to directly fabricating the driving structure 150b on the substrate by means of a semiconductor process, the present embodiment can reduce the warpage of the substrate 110 caused by the high-temperature process during the fabrication of the driving structure 150b, which allows the electronic device 100b of the present embodiment to have improved structural reliability.

In still another embodiment, one of the pin 141 and the pin 142 of the electronic component 140b can be connected to the first conductor layer 120b. For example, the pin 141 can be connected to the first conductor layer 120b through the second conductor layer 160b (not shown), and the other pin 142 is not connected to the first conductor layer 120b, but is mutually induced with the second conductor layer 160b and the first conductor layer 120b coupled to the pin 142 to achieve coupling, but the disclosure is not limited thereto.

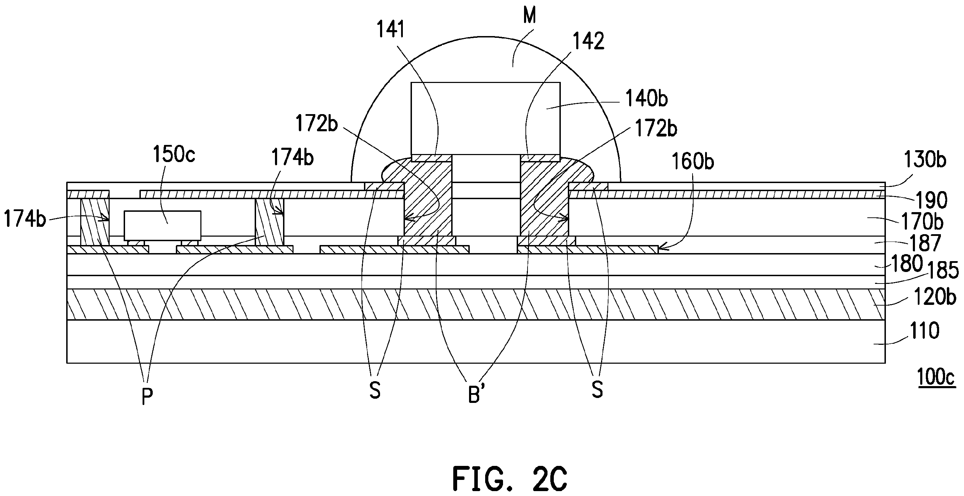

FIG. 2C is a schematic partial cross-sectional view of a main region in an electronic device according to still another embodiment of the disclosure. Please refer to FIG. 2B and FIG. 2C both. The electronic device 100c of this embodiment is similar to the electronic device 100b of FIG. 2B. The difference between the two is: in this embodiment, the second insulating layer 170b covers the driving structure 150c, as shown in FIG. 2C. In this embodiment, the driving structure 150c and the electronic component 140b can be respectively disposed on both sides of the second insulating layer 170b, which means that the electronic component 140b is located on the second insulating layer 170b, and the driving structure 150c is located under the second insulating layer 170b. In addition, the driving structure 150c of this embodiment is coupled to the electronic component 140b through the second conductor layer 160b. More specifically, the driving structure 150b is coupled with the electronic component 140b through the second conductor layer 160b, the conductive component P, the third conductor layer 190, the conductive pad S, and the solder B'. In this embodiment, the driving structure 150c can be formed on the third insulating layer 180 by means of a semiconductor process, but the disclosure is not limited thereto.

It should be noted that, please refer to FIG. 1, FIG. 2A, FIG. 2B, and FIG. 2C at the same time. In an embodiment, the electronic device 100a in FIG. 1 may be replaced by the electronic device 100b, or the electronic device 100c, or a combination of the electronic devices 100a, 100b, and 100c. That is, the features of the various embodiments can be mixed and matched freely as long as they do not violate the spirit of the disclosure or conflict each other. In addition, in another embodiment not shown, the substrate 110 can be selectively separated from the electronic device 100a, the electronic device 100b, or the electronic device 100c to form a flexible electronic device.

In summary, in the embodiment of the disclosure, since the electronic component is disposed on the first insulating layer and is coupled to the first conductor layer, and the driving structure is coupled to the electronic component, the electronic device of the disclosure can have improved structural reliability.

## Claims

1. An electronic device (100a, 100b, 100c), comprising:
a substrate (110);
a first conductor layer (120a, 120b), disposed on the substrate (110);
a first insulating layer (130a, 130b), disposed on the first conductor layer (120a, 120b);
an electronic component (140a, 140b), disposed on the first insulating layer (130a, 130b) and coupled to the first conductor layer (120a, 120b); and
a driving structure (150a, 150b, 150c), coupled to the electronic component (140a, 140b).

2. The electronic device (100a, 100b, 100c) according to claim 1, further comprising:
a second conductor layer (160a, 160b), which is disposed between the first conductor layer (120a, 120b) and the first insulating layer (130a, 130b), and is coupled to the electronic component (140a, 140b) and the driving structure (150a, 150b, 150c).

3. The electronic device (100a) according to claim 1, wherein the driving structure (150a) is disposed on the first insulating layer (130a).

4. The electronic device (100a) according to claim 3, wherein the first insulating layer (130a) has a first opening (132a) and a second opening (134a), the electronic component (140a) is coupled to the first conductor layer (120a) through the first opening (132a), and the driving structure (150a) is coupled to the first conductor layer (120a) through the second opening (134a).

5. The electronic device (100a, 100b) according to claim 1, further comprising:
a second insulating layer (170, 170b), disposed between the first conductor layer (120a, 120b) and the first insulating layer (130a, 130b).

6. The electronic device (100b) according to claim 5, wherein the driving structure (150b) is disposed on the second insulating layer (170b).

7. The electronic device (100b) according to claim 6, wherein the second insulating layer (170b) has a first opening (172b) and a second opening (174b), the electronic component (140b) is coupled to the first conductor layer (120b) through the first opening (172b), and the driving structure (150b) is coupled to the first conductor layer (120b) through the second opening (174b).

8. The electronic device (100c) according to claim 5, wherein the driving structure (150c) is arranged under the second insulating layer (170b).

9. The electronic device (100c) according to claim 8, further comprising:
a second conductor layer (160b), disposed between the first conductor layer (120b) and the first insulating layer (130b), wherein the driving structure (150c) is coupled to the electronic component (140b) through the second conductor layer (160b).

10. The electronic device (100a, 100b, 100c) according to claim 1, wherein the electronic component (140a, 140b) comprises a capacitor, an inductor, a variable capacitor, a filter, a resistor, a diode, a light emitting diode, a microelectromechanical system (MEMS) component, or a liquid crystal chip.

11. The electronic device (100a, 100b, 100c) according to claim 1, wherein from a top view of the electronic device (140a, 140b), a ratio of an area of the first conductor layer (120a, 120b) to an area of the substrate (110) is between 80% and 99%.

12. The electronic device (100a, 100b, 100c) according to claim 1, wherein the electronic component (140a, 140b) and the driving structure (150a, 150b, 150c) are coupled to the first conductor layer (120a, 120b) through a solder (B, B').

13. The electronic device (100a, 100b, 100c) according to claim 1, wherein a thickness of the first conductor layer (120a, 120b) is between 1µm and 20µm.

14. The electronic device (100a, 100b, 100c) according to claim 1, wherein the driving structure (150a, 150b, 150c) comprises an integrated circuit, micro integrated circuits, a transistor, a silicon controlled rectifier, a diode, a valve, or a thin film transistor.

15. The electronic device (100a, 100b, 100c) according to claim 1, wherein the driving structure (150a, 150b, 150c) comprises a second substrate and a thin film transistor formed on the second substrate, wherein the driving structure (150a, 150b, 150c) is bonded on the substrate (110).
